# EUROPÄISCHE PATENTSCHRIFT

(11) **EP 1 057 204 B1**
(45) Veröffentlichungstag und Bekanntmachung des Hinweises auf die Patenterteilung: **14.06.2006**
(21) Anmeldenummer: 98952539.9
(22) Anmeldetag: 29.08.1998
(51) Int. Cl.: H01J 37/153

(54) **ANORDNUNG ZUR KORREKTUR DES ÖFFNUNGSFEHLERS DRITTER ORDNUNG EINER LINSE, INSBESONDERE DER OBJEKTIVLINSE EINES ELEKTRONENMIKROSKOPS**
DEVICE FOR CORRECTING THIRD-ORDER SPHERICAL ABERRATION IN A LENS, ESPECIALLY THE OBJECTIVE LENS OF AN ELECTRONIC MICROSCOPE
SYSTEME DE CORRECTION DE L'ABERRATION SPHERIQUE DE TROISIEME ORDRE D'UNE LENTILLE, EN PARTICULIER DE L'OBJECTIF D'UN MICROSCOPE ELECTRONIQUE

(30) Priorität: 23.01.1998 DE 19802409
(43) Veröffentlichungstag der Anmeldung: 06.12.2000
(73) Patentinhaber: Ceos Corrected Electron Optical Systems GmbH, 69126 Heidelberg (DE)
(72) Erfinder: HAIDER, Maximilian, D-69251 Gaiberg (DE); UHLEMANN, Stephan, D-69126 Heidelberg (DE)
(74) Vertreter: Pöhner, Wilfried Anton, Dr.
(86) Internationale Anmeldenummer: PCT/DE1998/002597
(87) Internationale Veröffentlichungsnummer: WO 1999/038188

(56) Entgegenhaltungen:
- EP-A- 0 373 399
- EP-A- 0 451 370
- US-A- 4 414 474
- ROSE H, PREIKSZAZ D: "OUTLINE OF A VERSATILE CORRECTED LEEM" OPTIK, Bd. 92, Nr. 1, 1. November 1992, Seiten 31-44, XP000321916
- ROSE H: "Correction of aperture aberrations in magnetic systems with threefold symmetry" NUCLEAR INSTRUMENTS AND METHODS., Bd. 187, 1981, Seiten 187-199, XP002093135 AMSTERDAM NL in der Anmeldung erwähnt

## Beschreibung

Die Erfindung bezieht sich auf eine Anordnung zur Korrektur des Öffnungsfehlers dritter Ordnung einer Objektivlinse, insbesondere der Objektivlinse eines Elektronenmikroskops, bestehend aus der Objektivlinse und eines in Richtung des Strahlenganges nachgeschalteten Korrektivs, welches gebildet wird aus einem ersten und zweiten Hexapol,einem dazwischen angeordneten Rundlinsen-Dublett aus zwei Rundlinsen gleicher Brennweite, deren beiderseitiger Abstand dem Doppelten ihrer Brennweite entspricht, von denen sich jede im Brennpunktabstand von der Mittelebene des jeweils benachbarten Hexapols befindet.

Unter dem Begriff Öffnungsfehler werden all jene optischen Bildfehler zusammengefasst, die in der Gauß'schem Dioptrik durch jene Elementarbahn bestimmt werden, die in der abzubildenden Gegenstandsebene von der optischen Achse ausgehen. In hochauflösenden elektronenoptischen Systemen wird die Leistungsfähigkeit, d.h. das Auflösungsvermögen durch die Öffnungsfehler begrenzt. Ein Hauptanliegen der hochauflösenden Elektronenmikroskopie ist es deshalb, diese Öffnungsfehler zu beseitigen. Im Falle von Rundlinsensysteme mit gerader optischer Achse handelt es sich dabei um die sphärische Aberration dritter Ordnung. Als Korrektiv wurde bereits in der Zeitschrift "Nuclear Instruments and Methods" Bd. 187, 1981, Seite 187ff eine sich insbesondere für das Raster-Transmissions-Elektronenmikroskop geeignete Lösung vorgeschlagen. Es besteht in seinem grundsätzlichen Aufbau aus zwei Hexapolen, zwischen denen sich ein aus zwei Rundlinsen gleicher Brennweite gebildetes Rundlinsensystem befindet, deren Abstand voneinander zweimal ihrer Brennweite entspricht. Die beiden Hexapole befinden sich im Brennpunktabstand von der jeweils benachbarten Rundlinse, so daß die Mittelebene des ersten Hexapoles in die Mittelebene des zweiten Hexapoles abgebildet wird.
In der EP 0 451 370 B1 wird eine konkrete Anwendung dieses Korrektives zur Beseitigung des Öffnungsfehlers dritter Ordnung für eine als Objektiv dienende Rundlinse vorgeschlagen, bei der zwischen dem vorbeschriebenen Korrektiv und der Objektivlinse ein weiteres Rundlinsendublett eingebracht ist, das im Aufbau und in Anordnung zum eingangsseitigen Hexapol des Korrektives mit dem Rundlinsendublett des Korrektives übereinstimmt.
Als erheblicher Nachteil anzusehen ist, daß die Einstellung des Öffnungsfehlers des in der letztgenannten Druckschrift beschriebenen Korrektives einen erheblichen Einstellungs- und Justieraufwand erfordern. Außerdem kann in der dort beschriebenen Löschung ein einmal optimierter Korrektoraufbau nur in Verbindung mit einem Objektiv (für das er optimiert wurde) verwendet werden. Eine Anpassung an andere Obejektive (mit abweichender Brennweite und sphärischer Aberration) ist nur schwer oder gar nicht möglich und erfordert Änderungen im Korrektor selbst.

Hiervon ausgehend hat sich die Erfindung die Aufgabe gestellt, das vorbeschriebene Korrektiv zur Beseitigung des Öffnungsfehlers der sphärischen Aberration dritter Ordnung im optischen Strahlengang hinter einem Objektiv anzubringen und erstens eine einfache Anpassung in unterschiedliche Objektive und zweitens eine einfache Feineinstellung des Öffnungsfehlers zu ermöglichen.

Zur Lösung der erfindungsgemäßen Aufgabe werden zwei unabhängig voneinander realisierbare Lösungen angegeben.

In der erstbeschriebenen Lösung wird zwischen dem oben beschriebenen Korrektiv und der Objektivlinse eine Rundlinse angeordnet, die im Hinblick auf ihre Stärke und Position so einzustellen ist, daß sie zweierlei Bedingungen erfüllt: Sie soll zum einen den von der Objektivlinse ausgehenden Strahlengang als Parallelstrahl auf den Eingang des an sich bekannten Korrektives geben; hierin liegt eine Bedingung für die von der optischen Achse im Gegenstandspunkt ausgehende Fundamentalbahn. Zudem hat die Rundlinse die Aufgabe die komafreie Ebene der Objektivlinse in die komafreien Ebenen der Hexapole des Korrektives abzubilden. Hieraus folgt eine Bedingung für die außeraxiale Fundamentalbahn, welche in den komafreien Ebenen einen Knotenpunkt aufweist. Aus diesen Bedingungen folgt weiterhin, daß die axiale Fundamentalbahn die optische Achse vor der Rundlinse schneidet, so daß im kurzen Abstand vor der Rundlinse ein Zwischenbild entsteht. Zur Abgrenzung gegenüber der EP 0 451 370 ist darauf hinzuweisen, daß sich dort im Gegensatz hierzu das Zwischenbild im Unendlichen befindet und die Verwendung einer weiteren Rundlinse zwingend erforderlich macht.

Die Konstruktion des Zustandes vollständiger Korrektur macht folgende Schritte erforderlich:

Ausgegangen wird hierzu von dem fest und optimal eingestellten Korrektiv. Anschließend wird die erfindungsgemäß zwischen Objektivlinse und Korrektiv eingebrachte Rundlinse entlang der optischen Achse zur Optimierung der Vergrößerung bzw. zur Anpassung der Bahnhöhe der axialen Fundamentalbahn in ihrer Position verschoben und deren Linsenstärke einjustiert. Als letzter Schritt folgt die Anpassung der Objektivlinse durch Änderung deren Stärke. Hierbei ist die Stärke der Änderung der Objektivlinse vergleichsweise gering und beträgt für typische Objektive weniger als 10%. Die Anpassung und Einjustierung des Zustandes vollständiger Korrektur erfolgt damit primär über Anordnung und Einstellung der Rundlinse in der angegebenen Weise. Zur Justierung des Korrekturzustandes ergeben sich keine wesentlichen Nachteile im Hinblick auf die Koeffizienten der Bildfehler. Der entscheidende Vorteil ist darin zu sehen, daß nicht das Korrektiv entsprechend dem Öffnungsfehler und der Brennweite der Objektivlinse und dem gewünschten Restöffnungsfehler anzupassen ist, was im Hinblick auf die Zahl der zu ändernden Elemente des Korrektives und in Hinblick auf dessen Stabilität erhebliche und umfangreiche Justierprobleme mit sich bringen würde. Die erfindungsgemäß vorgeschlagene Anpassung mit Hilfe der Rundlinse ist hingegen einfach und unproblematisch durchführbar.

Neben der wesentlichen Vereinfachung der Justierung ergibt sich im Hinblick auf den Stand der Technik eine wesentliche Vereinfachung des apparativen Aufbaues, da nurmehr noch eine einzige Rundlinse einzusetzen ist. Hieraus folgt zum Beispiel, daß für die räumliche Unterbringung dieser Rundlinse, die im Objektivpolschuh zu erfolgen hat und hierdurch begrenzt ist, gerade in radialer Hinsicht ausreichend Raum zur Verfügung steht. Darüber hinaus ist auch die aufzuwendende Kühlleistung wesentlich reduziert.

Die vorbeschriebene Korrekturanordnung hat zum Ziel, die sphärische Aberration dritter Ordnung völlig zu eliminieren. Der Vollständigkeit halber ist klarzustellen, daß im Betrieb zur Erzeugung eines Phasenkontrastes die sphärische Aberration nicht zu Null, sondern zu einem Wert heruntergefahren wird, der etwa 1 bis 5 % des ursprünglichen Wertes beträgt. Diese Einstellung des geringen Bildfehlers dritter Ordnung erfolgt durch Einjustierung über Änderung der Stärke der Rundlinse und nicht des Korrktors, wie bei der bekannten Lösung.

Auch hierzu ist also die erfindungsgemäße Korrekturanordnung vorzüglich geeignet.

Eine weitere, hiervon völlig unabhängige Lösung der Aufgabe ist dadurch gekennzeichnet, daß die Brennweiten der Rundlinsen des Dubletts zwischen Objektiv und Korrektor unterschiedlich sind, der Abstand der objektivnahen Rundlinse von der komafreien Ebene des Objektivs gleich deren Brennweite ist, der Abstand der korrektivnahen Rundlinse von der komafreien Ebene des Korrektivs gleich deren Brennweite ist und der Abstand beider Rundlinsen gleich der Summe deren Brennweiten ist.

Diese Lösung ist im Hinblick auf die Zahl der verwendeten Elemente identisch zu der in der EP 0 451 370 angegebenen Lösung, mit entscheidenden Unterschieden in der räumlichen Anordnung der beiden Rundlinsen zwischen der Objektivlinse und dem Korrektiv sowie deren Brennweiten. Hier wird ausdrücklich und in Abweichung zu der dort vorgeschlagenen Lösung gefordert, daß die Brennweiten dieser beiden Rundlinsen unterschiedlich sind und die räumliche Anordnung in der Weise erfolgt, daß der Abstand der objektivnahen Rundlinse von der komafreien Ebene des Objektivs gleich deren Brennweite und der Abstand der zweiten, korrektivnahen Rundlinse von der komafreien Ebene des Korrektives bzw. der komafreien Ebene des eingangsseitigen Hexapols gleich deren Brennweite ist. Hinzu kommt, daß der Abstand beider Rundlinsen gleich der Summe beider Brennweiten ist. Letzte Forderung geht im Grenzfall der Identität der beiden Brennweiten in die Forderung gemäß der EP 0 451 370 über.

Die Anpassung des Korrektors an ein geg. Objektiv erfolgt ähnlich der vorbeschriebenen Lösung. Ausgehend von einem optimierten, also auf festen Wert eingestellten Korrektiv wird zwischen die Objektivlinse und das Korrektiv die aus zwei Rundlinsen bestehende Anordnung eingebracht. Durch Festlegung der Brechkraft und der Position der beiden Rundlinsen erhält man eine Anpassung an die Objektivlinse. Dadurch wird nicht nur die Korrektur für eine Objektivlinse mit einem bestimmten Wert der sphärischen Aberration möglich, sondern es läßt sich die Korrektur der sphärischen Aberration beeinflussen dahingehend, daß durch ein- und dasselbe Korrektiv die verschiedenen Werte der sphärischen Aberration bei verschiedenen Objektivlinsen kompensiert werden können. In vorteilhafter Weise ist eine Anpassung des Korrektivs an den jeweiligen Wert der sphärischen Aberration der Objektivlinse nicht zwingend erforderlich. Eine konstruktive Anpassung des Korrektives an die jeweilige Objektivlinse erübrigt sich demzufolge, da die Anpassung über die Einstellung und geeignete Positionierung der Rundlinsen erfolgt. Auch hier erfolgt eine Anpassung des auf optimale Verhältnisse voreingestellten Korrektives an die jeweilige Objektivlinse mit ihrem jeweiligen Wert der sphärischen Aberration über Einstellung und geeignete Positionierung der dazwischen angeordneten beiden Rundlinsen.

Gegenüber der vorgenannten Lösungsalternative bestehen jedoch in baulicher Hinsicht Nachteile, die aufgrund der Integration zweier Rundlinsen einen ein vorgegebenes Volumen entstehen und eine erhöhte Kühlleistung sowie einen komplizierten Aufbau zur Folge haben, wie im Falle der bekannten Lösung.

In einer Weiterbildung wird vorgeschlagen, die Brennweite der korrektivnahen Rundlinse kleiner als die Brennweite der objektivnahen Rundlinse zu wählen. Bei einer derartigen Anordnung erhält man eine Verringerung der Korrekturwirkung des Öffnungsfehlers.

Im entgegengesetzten Fall einer größeren Brennweite der korrektivnahen Rundlinse hingegen erhält man eine Vergrößerung der Korrekturwirkung.

Weitere Einzelheiten, Merkmale und Vorteile lassen sich dem nachfolgenden Beschreibungsteil entnehmen, in dem anhand der Zeichnung jeweils ein Ausführungsbeispiel der Erfindung in prinzipienhafter Darstellung wiedergegeben ist. Es zeigen:
- Figur 1:: den Strahlengang einer Korrekturanordnung, bei der zwischen Objektivlinse und Korrektiv eine einzige Rundlinse angeordnet ist,
- Figur 2:: eine Anordnung, bei der zwischen Objektivlinse und Korrektiv zwei Rundlinsen unterschiedlicher Brennweite angeordnet sind.

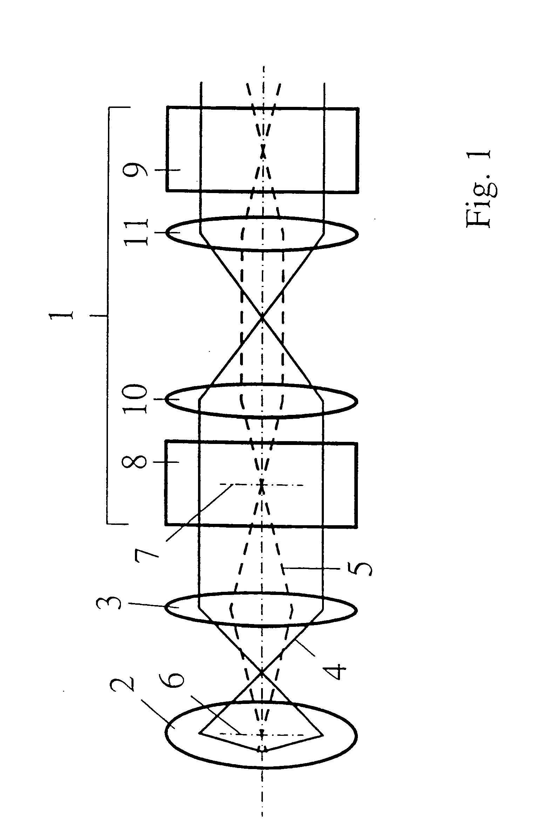

In Figur 1 ist der Strahlengang der beiden Fundamentallösungen der Gauß'schen Dioptrik in den einzelnen optischen Elementen der Korrekturanordnung bestehend aus einem Korrektiv (1), einer Objektivlinse (2) und einer dazwischen angeordneten Rundlinse (3) wiedergegeben. Die von der optischen Achse ausgehende Fundamentalbahn der Gauß'schen Dioptrik ist mit (4) und die außeraxiale Fundamentalbahn mit (5) bezeichnet. Die komafreie Ebene (6) der Objektivlinse (2) wird durch den Knotenpunkt der außeraxialen Bahn (5) beschrieben. Die Rundlinse (3) wird so angeordnet, daß die Bahn (5) so gebrochen wird, daß der nächste Knotenpunkt in der komafreien Ebene (7) des ersten Hexapols des Korrektives (1) zu liegen kommt. Die axiale Bahn (4) durchstößt die optische Achse, wo ein Zwischenbild entsteht und wird durch die Rundlinse (3) parallel auf das Korrektiv gerichtet. Ihre Bahnhöhe läßt sich durch Verschieben der Rundlinse (3) in Richtung der optischen Achse beeinflussen.

Während es Betriebs des Gesamtsystems kann später die Feineinstellung der sphärischen Aberration durch geeignete Variation der Stärken der Linsen (2) und (3) erfolgen.

Das Korrektiv selbst besteht in an sich bekannter Weise aus zwei, jeweils außen liegenden Hexapolen (8, 9) und einem dazwischen befindlichen Rundlinsendublett, bestehend aus zwei Rundlinsen (10, 11) von gleicher Brennweite, deren Abstand der doppelten Brennweite entspricht. Der Abstand zwischen der Rundlinse zu ihrem benachbarten Hexapol entspricht jeweils ebenfalls der Brennweite. Dieses an sich bekannte Korrektiv dient der Beseitigung der sphärischen Aberration dritter Ordnung.

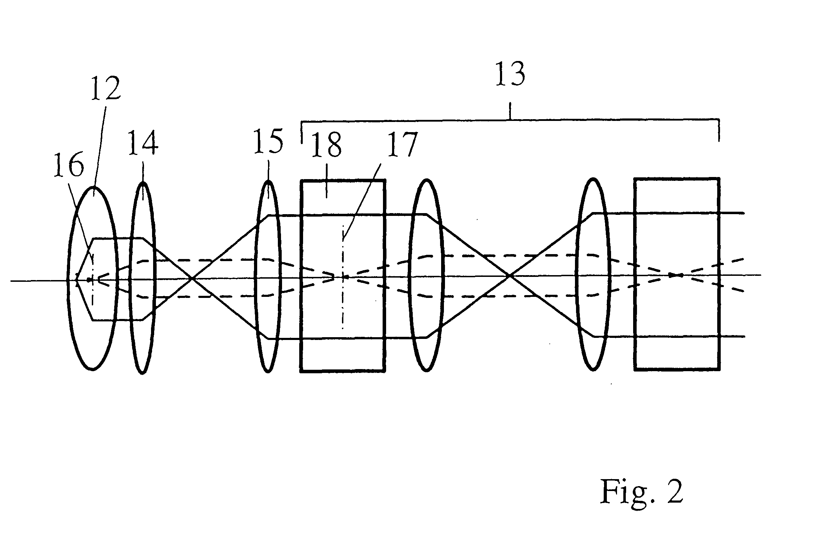

In Figur 2 ist ebenfalls der Strahlengang zwischen der Objektivlinse (12) und dem Korrektiv (13) im einzelnen anhand der Fundamentalbahnen der Gauß'schen Dioptrik beschrieben, wobei das Korrektiv (13) mit dem vorbeschriebenen Korrektiv (1) in identischer Weise übereinstimmt, so daß zur Vermeidung von Wiederholung auf ein nochmaliges Beschreiben verzichtet wird.

Im Unterschied hierzu befinden sich zwischen der Objektivlinse (12) und dem Korrektiv (13) nunmehr zwei Rundlinsen (14, 15) von jeweils unterschiedlicher Brechkraft. Die Anordnung erfolgt in der Weise, daß die erste Rundlinse (14) von der komafreien Ebene (16) der Objektivlinse (12) im Abstand ihrer Brennweite angeordnet ist. Die zweite Rundlinse (15) ist hiervon einerseits im Abstand der Summe der Brennweiten der beiden Rundlinsen (14, 15) von der objektivseitigen Rundlinse (14) entfernt und andererseits im Abstand ihrer Brennweite von der komafreien Ebene (17) des ersten Hexapols (18) im Abstand ihrer Brennweite angeordnet.

Für ein voreingestelltem Korrektiv erfolgt eine Anpassung über die Einstellung der Brechkraft und die Festlegung der Position der beiden Rundlinsen (14, 15) an die jeweilige Objektivlinse (12). Unter Beibehaltung der Einstellung des Korrektives erfolgt die Anpassung an die jeweiligen Werte der sphärischen Aberration der jeweiligen Objektivlinse (12), so daß es möglich wird, ein- und dasselbe Korrektiv (13) für Objektive mit unterschiedlichen Werten der Brennweite und sphärischen Aberration einzusetzen.

Im Ergebnis zeigen beide Figuren jeweils Lösungen auf, durch die mit geringem Justieraufwand ein voreingestelltes und optimiertes Korrektiv an die jeweiligen Objektivlinsen angepaßt werden kann, und bei dessen mit Hilfe von Rundlinsen der jeweils gewünschten Restöffnungsfehler eingestellt werden kann.

## Patentansprüche

1. Anordnung zur Korrektur des Öffnungsfehlers dritter Ordnung einer Objektivlinse, insbesondere der Objektivlinse eines Elektronenmikroskops, bestehend aus der Objektivlinse und eines in Richtung des Strahlenganges nachgeschalteten Korrektivs, welches gebildet wird aus einem ersten und zweiten Hexapol, einem dazwischen angeordneten Rundlinsen-Dublett aus zwei Rundlinsen gleicher Brennweite, deren beiderseitiger Abstand dem Doppelten ihrer Brennweite entspricht, von denen sich jede im Brennpunktabstand von der Mittelebene des jeweils benachbarten Hexapols befindet.
**dadurch gekennzeichnet,**
**daß** zwischen Objektivlinse (2) und Korrektiv (1) eine einzige Rundlinse (3) angeordnet ist, die so eingestellt ist, daß zum einen der Strahlengang parallel auf das Korrektiv (1) trifft und zum anderen die komafreie Ebene (6) der Objektivlinse in die komafreie Ebene (7) des Hexapols (8) des Korrektivs (1) abgebildet wird.

2. Anordnung zur Korrektur des Öffnungsfehlers dritter Ordnung einer Objektivlinse, insbesondere der Objektivlinse eines Elektronenmikroskops, bestehend aus der Objektivlinse und eines in Richtung des Strahlenganges nachgeschalteten Korrektivs, welches gebildet wird aus
einem ersten und zweiten Hexapol,
einem dazwischen angeordneten Rundlinsen-Dublett aus zwei Rundlinsen gleicher Brennweite, deren beiderseitiger Abstand dem Doppelten ihrer Brennweite entspricht,
von denen sich jede im Brennpunktabstand von der Mittelebene des jeweils benachbarten Hexapols befindet,
wobei zwischen Objektivlinse und Korrektiv zwei Rundlinsen angeordnet sind, **dadurch gekennzeichnet, daß** die Brennweiten der Rundlinsen (14, 15) unterschiedlich sind,
- der Abstand der objektivnahen Rundlinse (14) von der komafreien Ebene (16) des Objektivs gleich deren Brennweite ist,
- der Abstand der korrektivnahen Rundlinse (15) von der komafreien Ebene (17) des Korrektivs gleich deren Brennweite ist und
- der Abstand beider Rundlinsen (14, 15) gleich der Summe deren Brennweiten ist.

3. Anordnung gemäß Anspruch 2, **dadurch gekennzeichnet, daß** zur Verringerung der Korrekturwirkung des Korrektors die Brennweite der zweiten Rundlinse (15) kleiner ist als die Brennweite der ersten Rundlinse (14).

4. Anordnung gemäß Anspruch 2, **dadurch gekennzeichnet, daß** zur Vergrößerung der Korrekturwirkung des Korrektors die Brennweite der zweiten Rundlinse (15) größer ist als die Brennweite der ersten Rundlinse (14).

## Claims

1. Apparatus for correcting third-order spherical aberration in an objective lens, especially the objective lens of an electron microscope, comprising an objective lens and in the direction of the optical path a downstream correction device, which is formed by a first and a second hexapole and a round-lens doublet arranged therebetween and comprising two round lenses with the same focal length, the distance between the two lenses being twice their focal length and each being located at the focal point distance from the centre plane of the respective adjacent hexapole, **characterised in that**
a single round lens (3) is arranged between the objective lens (2) and the correction device (1) and is adjusted such that, first, the ray path impinges in parallel on the correction device (1) and, second, the coma-free plane (6) of the objective lens is imaged in the coma-free plane (7) of the hexapole (8) of the corrective (1).

2. Apparatus for correcting the third-order spherical aberration of an objective lens, in particular the objective lens of an electron microscope, comprising the objective lens and a correction device which is arranged downstream in the direction of the ray path and is formed from a first and a second hexapole,
and a round-lens doublet arranged therebetween and comprising two round lenses with the same focal length, whereby the distance between the two lenses is twice their focal length,
each being located at the focal point distance from the centre plane of the respective adjacent hexapole,
two round lenses being located between the objective lense and correction device, **characterised in that** the focal lengths of the round lenses (14, 15) are different,
- the distance of the round lens (14) close to the objective from the coma-free plane (16) of the objective is equal to the focal length thereof,
- the distance of the round lens (15) close to the objective from the coma-free plane (17) of the correction device is equal to the focal length thereof, and
- the distance between both round lenses is equal to the sum of both focal lengths.

3. Apparatus according to claim 2, **characterised in that**, to reduce the correction effect of the corrector, the focal length of the second round lens (15) is smaller than the focal length of the first round lens (14).

4. Apparatus according to claim 2, **characterised in that**, to increase the correction effect of the corrector, the focal length of the second round lens (15) is greater than the focal length of the first round lens (14).

## Revendications

1. Disposition pour corriger l'erreur d'ouverture de troisième ordre d'une lentille d'objectif, notamment de la lentille d'objectif d'un microscope électronique, composée de la lentille d'objectif et d'un correctif disposé en aval du chemin optique, qui est constituée d'un premier et d'un deuxième hexapole, d'un doublet de lentilles rondes intercalé de deux lentilles rondes de même distance focale, dont la distance réciproque correspond au double de la distance focale, dont chacune se trouve dans la distance focale du niveau médian de chacun des hexapoles voisins
**caractérisée par le fait**
**qu'**une seule lentille ronde (3) est disposée entre la lentille d'objectif (2) et le correctif (1), qui est réglée de telle manière que, d'une part le chemin optique touche parallèlement le correctif (1) et d'autre part le niveau sans coma (6) de la lentille d'objectif est reproduit dans le niveau sans coma (7) de l'hexapole (8) du correctif (1).

2. Disposition pour corriger l'erreur d'ouverture de troisième ordre d'une lentille d'objectif, notamment de la lentille d'objectif d'un microscope électronique, composée de la lentille d'objectif et d'un correctif disposé en aval, en direction du chemin optique, lequel est formé
d'un premier et d'un deuxième hexapole,
d'un doublet de lentilles rondes intercalé de deux lentilles rondes de même distance focale, dont la distance réciproque correspond au double de leur distance focale,
dont chacune se trouve dans la distance focale du niveau médian de chacun des hexapoles voisins,
sachant que deux lentilles rondes sont disposées entre la lentille d'objectif et le correctif, **caractérisée par le fait que** les distances focales des lentilles rondes (14, 15) sont différentes,
- la distance de la lentille ronde (14) proche de l'objectif du niveau sans coma (16) de l'objectif est égale à leur distance focale,
- la distance de la lentille ronde (15) proche du correctif du niveau sans coma (17) du correctif est égale à leur distance focale et
- la distance des deux lentilles rondes (14, 15) est égale à la somme de leurs distances focales.

3. Disposition selon la revendication 2, **caractérisée par le fait que**, pour réduire l'effet de correction du correcteur, la distance focale de la seconde lentille ronde (15) est inférieure à la distance focale de la première lentille ronde (14).

4. Disposition selon la revendication 2, **caractérisée par le fait que**, pour agrandir l'effet de correction du correcteur, la distance focale de la seconde lentille ronde (15) est supérieure à la distance focale de la première lentille ronde (14).
